# EUROPEAN PATENT SPECIFICATION

(11) **EP 4 506 695 B1**
(45) Date of publication and mention of the grant of the patent: **21.10.2026**
(21) Application number: 23191066.2
(22) Date of filing: 11.08.2023
(51) Int. Cl.: G01R 13/02, G01R 31/319

(54) **MEASUREMENT APPLICATION DEVICE, METHOD, AND COMPUTER PROGRAM PRODUCT**
MESSANWENDUNGSVORRICHTUNG, VERFAHREN UND COMPUTERPROGRAMMPRODUKT
DISPOSITIF D'APPLICATION DE MESURE, PROCÉDÉ ET PRODUIT DE PROGRAMME INFORMATIQUE

(43) Date of publication of application: 12.02.2025
(73) Proprietor: Rohde & Schwarz GmbH & Co. KG, 81671 München (DE)
(72) Inventor: GALLER, Florian, 86415 Mering (DE); HAMMER, Jakob, 82276 Adelshofen (DE)
(74) Representative: Novagraaf Group

(56) References cited:
- US-A1- 2004 174 818
- US-A1- 2016 080 667
- US-A1- 2023 019 734

## Description

### TECHNICAL FIELD

The disclosure relates to a measurement application device. Further, the present disclosure relates to a respective method, and a respective computer program product.

### BACKGROUND

Although applicable to any type of measurement application device with a user display, the present disclosure will mainly be described in conjunction with measurement devices like oscilloscopes, vector network analyzers (VNAs), and signal analyzers.

Users of modern measurement application devices may sometimes need to compare measured data with data provided e.g., in datasheets. For example, a user may want to compare a diagram from a datasheet with the actually measured waveform.

Comparing the measured signals with other data usually requires storing the measured signals, and manually comparing the stored signals with the reference data e.g., data from a datasheet.

Document US 2004/174818 A1 discloses a primary test and measurement device that merges a primary (i.e., local) and a non-primary (i.e., remote) waveform data to produce a display signal that, when presented on a display shows both waveforms.

Document US 2016/080667 A1 discloses a test and measurement tool configured to generate measurement data, and an imaging tool configured to generate image data, and a processor in communication with the imaging tool and the test and measurement tool.

There is a need for improving data analysis with modern measurement application devices.

### SUMMARY

The above stated problem is solved by the features of the independent claims.

The present disclosure is based on the finding that for users of modern measurement application devices it may be difficult to compare a graph of a measured signal with reference data, like a graph from a datasheet.

A user may for example store the measurement data with the measurement device, load the stored measurement data on a PC and then manually compare the measured graph with a reference data graph. This is, however, very time consuming.

The present disclosure, therefore, provides the measurement application device and the method for operating a measurement application device that both allow a user to easily use such reference data during his measurement.

Generally, a measurement application device according to the present disclosure may comprise any device that may be used in a measurement application to acquire an input signal, or to perform additional or supporting functions in a measurement application. A measurement application device may also comprise or be implemented as application or applications, also called measurement application or measurement applications herein, that may be executed on a computer device and that may communicate with other measurement application devices in order to perform a measurement task. A measurement application, also called measurement setup, may e.g., comprise at least one or multiple different measurement application devices for performing electric, magnetic, or electromagnetic measurements, especially on single devices under test. Such electric, magnetic, or electromagnetic measurements may be performed in a measurement laboratory or in a production facility in the respective production line. A measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test. In embodiments, at least one addition signal generation section for generating electric, magnetic, or electromagnetic signals may be provided in the device under test. A signal acquisition section may comprise, but is not limited to, a front-end for acquiring, filtering, and attenuating or amplifying electrical signals. The signal generation section may comprise, but is not limited to, respective signal generators, amplifiers, and filters.

Further, when acquiring signals, measurement application devices may comprise a signal processing section that may process the acquired signals. Processing may comprise converting the acquired signals from analog to digital signals, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a signal analyzer, a spectrum analyzer, or a vector network analyzer.

Of course, at least some of the possible functions, like signal acquisition and signal generation, may be combined in a single measurement application device.

In embodiments, which do not form part of the claimed invention the measurement application device may comprise pure data acquisition devices that are capable of acquiring an input signal and of providing the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

The measurement application device according to the present disclosure comprises a measurement signal interface, and a display that is coupled to the measurement signal interface. The measurement signal interface serves for acquiring a measurement signal with the measurement application device. The display may then display a graph or waveform of the acquired measurement signal. The display and the measurement signal interface of the measurement application device may be embodied as in other common measurement application devices.

For example, the measurement signal interface may be the signal acquisition interface of an oscilloscope, a vector network analyzer, or a signal analyzer, and the display may be the display of the respective device.

In other embodiments, as indicated above, the measurement signal interface may comprise a data interface, wherein the measurement signal may be acquired via the data interface in a digitized form. In such an embodiment, the measurement application device may be provided e.g., as a remote-control or measurement data analysis application for remotely controlling a measurement application device. Such a remote-control or measurement data analysis application may e.g., be a website that may be loaded from a server to a user device, like a computer, smartphone, or tablet PC. The website may comprise interactive elements, that may e.g., be provided using JavaScript programs, that allow the website to perform the functions disclosed herein for the measurement application device. In other embodiments, the remote-control or measurement data analysis application may be provided as native application that may be executed by the operating system of a respective user device. The measurement signal may be provided by any other adequate type of measurement application device, especially by a measurement application device without a dedicated display, as exemplarily explained above, or by a data storage.

Especially, the computer program product according to the present disclosure may in any embodiment disclosed herein comprise instruction for implementing the method as a purely computer implemented method that is executed by a processor. Such a method may comprise steps of acquiring data or user input, or of outputting data or providing information to a user. It is understood, that in the case of a purely computer implemented method the method may comprise instructions that cause the processor to access peripherals of the computer that carries the processor that executes the instructions. If no other information is provided herein, the respective peripherals are those peripherals of the computer that perform the same function as the respective elements of the measurement application device described as performing the respective function.

The measurement application device according to the present disclosure further comprises a graphics acquisition interface that serves for acquiring graphical data. The graphical data may comprise reference data that a user requires for analyzing the measurement signal. Such reference data may e.g., be provided in a datasheet, especially a datasheet of the device under test, DUT, that is analyzed to acquire the measurement signal.

The graphics acquisition interface may comprise any type of data interface that allows acquiring the graphical data. Such a data interface may e.g., comprise a USB interface that allows connecting a USB data carrier to the measurement application device. The data interface may also comprise a network interface for accessing network storages. In embodiments, the data interface may comprise a network interface with a web browser application that allows a user to download the graphical data e.g., in the form of images or documents, from the internet or a local web server. Another type of data interface may comprise a camera interface that allows a user to take a picture of the required graphical data e.g., from a printed manual or datasheet. The camera may e.g., comprise a USB camera, or an application installed on a mobile device, like a smartphone, that uses the devices' camera and transmits the image to the measurement application device. A further type of graphics acquisition interface may comprise the function of taking or recording a screenshot on a computer or measurement application device, and providing the screenshot as graphical data. Such a function may be provided by an operating system or an application executed on a user device or a measurement application device. In an exemplary embodiment, a user may e.g., open a document, like a PDF document, and with the mouse or on a touchscreen with his fingers define the section to be recorded in the screenshot. A combination of the above interfaces is also possible in a measurement application device.

The network interface may comprise any kind of wired and wireless communication interfaces, like for example an Ethernet, wireless LAN or WIFI interface, a USB interface, a Bluetooth interface, an NFC interface, a visible or non-visible light-based interface, especially, an infrared interface.

In embodiments, the graphical data may be provided in the form of images or documents containing the images. The images may e.g., be provided as JPG, GIF, SVG files or any other type of graphics files. If a document is provided, such a document may be provided e.g., as PDF document or a document of an office program, like Microsoft Office or LibreOffice.

Further, a data processor is provided in the measurement application device. The data processor is coupled to the graphics acquisition interface, and the display. The data processor extracts a graph from the graphical data, and then controls the display to display the extracted graph on the display, especially together with the measurement signal. It is understood, that different techniques for extracting the graph may be used by the data processor, as will be explained in more detail below.

Extracting the graph may be performed based on respective user input. The graphical data may e.g., be shown to the user, and the user may then draw a rectangle that defines the graph to be extracted. Extraction in this embodiments may refer to, but is not limited to, cutting out or copying the marked rectangle.

Displaying the graph may be performed e.g., by underlying or overlaying the extracted graph under the actual measurement interface displayed by the measurement application device. In such an embodiment, the extracted graph may be used as a background or kind of wallpaper for the screen of the measurement application device. The extracted graph may be shown with different graphical properties than the measurement signal. The extracted graph may e.g., be shown in another color, or another curve type, like a dashed or a dotted curve.

In other embodiments, the extracted graph may be presented side-by-side with the user interface of the measurement application device on the display.

The data processor may comprise or may be provided in or as part of at least one of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. The data processor may at least in part also be provided as a computer program product comprising computer readable instructions that may be executed by a processing element. In a further embodiment, the data processor may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and clock generation circuitry.

With the help of the measurement application device according to the present disclosure, a user may easily combine reference data with actually measured data directly in the measurement application device. There is no need to further copy the measurement data to a computer and manually process this data there.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the measurement application device can be combined in all variations with each other and the disclosure of the description is not limited to the claim dependencies as specified in the claim set. Further, the features of the other independent claims may be combined with any of the features of the dependent claims relating to the apparatus in all variations, wherein respective method steps perform the function of the respective apparatus elements.

In an embodiment, which can be combined with all other embodiments of the measurement application device mentioned above or below, the data processor may be further configured to extract a trace of the graph from the graphical data.

The data processor may not only, as described above, copy, or cut out a rectangle as marked by a user. Instead, the data processor may also extract a trace of the graph. The trace in this regard refers to a curved object in the graphical data that represents the actual values of e.g., a characteristic curve for an electronic device. Such a trace may be provided e.g., in a two-axis diagram in the graphical data.

In an embodiment, the data processor may apply a feature extraction algorithm for separating the trace from the other content in the graphical data. Such a feature extraction algorithm may use known techniques for identifying the curved object in the graphical data, and may e.g., search for the axes of a diagram and the content framed by the axes. While the axes may be identified as horizontal and vertical lines, the content may be identified as any other curved object that is framed by the detected axes. In other embodiments, an artificial intelligence-based algorithm may also be used to extract the trace of the graph.

It is understood, that the trace may be extracted as two-dimensional object or in a two-dimensional coordinate system. The trace may be extracted e.g., as pairs of X-Y-coordinates of single points of the trace. In order to display the full trace, the dots may be drawn, and if required connected by lines or by fitting a curve into the points.

In other embodiments, the trace may be provided as an image or image file, wherein the trace is drawn as line in the image or image file, and the other content is just a transparent background. Such an embodiment allows easily displaying the trace, and scaling or adjusting the position and orientation of the trace on a display. In further embodiments, a user may select the trace manually.

In further embodiments, the data processor may allow a user to provide the trace of the graph e.g., by drawing or following the trace on screen, for example, with a mouse or on a touch screen with his finger.

With the extracted trace, the data processor may also determine the exact or raw values of the trace.

In another embodiment, which can be combined with all other embodiments of the measurement application device mentioned above or below, the measurement application device may further comprise a user input interface configured to receive at least one of a unit of at least one coordinate system axis of a coordinate system comprising the graph in the graph data, and a value range of the at least one coordinate system axis in the graphical data, and a scaling of the at least one coordinate system axis in the graphical data. The data processor may further be configured to adapt the displaying of the extracted graph according to the received at least one of a unit of at least one coordinate system axis of a coordinate system comprising the graph, and a value range of the at least one coordinate system axis from the graphical data, and a scaling of the at least one coordinate system axis from the graphical data.

With the user input interface, a user may manually fit the extracted graph with the measurement signal i.e., with the diagram showing a trace or graph of the measurement signal.

The user may e.g., be provided with a user input interface that allows visually dragging the extracted graph to position and scale the graph. Positioning may be enabled by a user selecting a spot within the graph and dragging the graph, and scaling may be enabled by a user selecting a corner or an edge of the graph and moving the corner or edge accordingly. Rotating may be enabled e.g., by selecting the graph with an additional key pressed, or by selecting a special icon shown with the graph.

The user input interface may comprise any type of user input interface, like a mouse, a keyboard, a touchscreen, a trackball, switches, and button.

In a further embodiment, which can be combined with all other embodiments of the measurement application device mentioned above or below, the data processor may further be configured to extract at least one of a unit of at least one coordinate system axis of a coordinate system comprising the graph in the graphical data, and a value range of the at least one coordinate system axis from the graphical data, and a scaling of the at least one coordinate system axis from the graphical data.

Usually, coordinate systems comprise two or three axes, and every axis is provided with an indication of the unit it represents. Such units may e.g., refer to any physical unit as defined in the SI or International System of Units. Of course, any other unit is also possible.

The axes are usually marked by a text-based indication of the respective unit. Such a text-based indication may usually be provided as horizontal writing on all axes, or as horizontal writing on the horizontal axis, and as vertical writing on the vertical axis.

The data processor may, therefore, comprise an OCR (optical character recognition) function and apply this OCR function to the graphical data, to identify the units that are represented in a diagram in the graphical data. This OCR function may be adapted to identify vertically, horizontally, and arbitrarily rotated text.

The data processor may also combine the above-described feature detection to identify a possible coordinate system in the graphical data, and may then apply the OCR function only to the relevant sections around the coordinate system axes in the graphical data. As indicated above, in another embodiment, an artificial-intelligence based algorithm may also be used to identify the axes and the units provided at the axes.

In addition to a unit, axes of coordinate systems are usually provided with an indication of the value range, and a scaling of the respective axes. Such an indication may be provided in the form of numbers with a respective abbreviation of the unit. For example, a number and the SI unit, like 100 Hz, 1000 Hz, 10 V, 500 V, or any other unit, like dB, dBm, °, or a combination of units, like dBc/Hz.

In embodiments, the data processor may determine the scaling of the numbers e.g., based on the added unit indication. The units may e.g., comprise a scaling indication like mega-, giga- or milli-. Such units may read as e.g., 100 GHz (gigahertz), 10 mV (millivolt), 5 MHz (megahertz). It is understood, that these examples are just exemplarily shown, and that any other scaling is also possible.

The data processor may in embodiments also identify such a scaling of the axes of the respective coordinate system. To this end, the data processor may apply the OCR function and analyze the extracted texts accordingly. The application of an artificial-intelligence-based algorithm is also possible.

The same applies to the value range. The value range is usually indicated by the numbers indicated on the axes of a coordinate system. This value indications allow mapping the value of the graph on one axis of the coordinate system to the values of the other axis of the coordinate system.

The data processor may in embodiments also identify such a value range of the axes of the respective coordinate system. To this end, the data processor may apply the OCR function and analyze the extracted texts accordingly. The application of an artificial-intelligence-based algorithm is also possible.

In embodiments, the data processor may also be configured to convert values between different units. For example, a value provided in millivolts [mV], may be converted into a value in volts [V], or dBV. A value measured in dBm may be converted into watts [W].

In an embodiment, which can be combined with all other embodiments of the measurement application device mentioned above or below, the data processor may further be configured to adapt the displaying of the extracted graph according to the extracted at least one of a unit of at least one coordinate system axis of a coordinate system comprising the graph, and a value range of the at least one coordinate system axis from the graphical data, and a scaling of the at least one coordinate system axis from the graphical data.

The data processor may use the knowledge of the scaling of the identified graph, and the internal knowledge of the user-provided or user-configured scaling of the measurement signal on a display of the measurement application device to automatically fit the extracted graph with the measurement signal.

To this end, the data processor may scale, rotate, and move the extracted graph such that the scaling, the orientation, and the positioning of the extracted graph matches the measurement signal's scaling, orientation, and positioning.

The data processor may e.g., be configured to move the extracted graph until the origins of the diagram showing the measurement signal and that of the extracted graph match. Then the data processor may rotate the extracted graph, if necessary, such that respective axes of the graph overlay the horizontal and vertical axes of the diagram showing the measurement signal. Finally, the data processor may scale the single axes such that the scaling of all axes of the diagram showing the extracted graph matches the scaling of the axes of the diagram showing the measurement signal. Again, this scaling, orienting, and positioning may also be performed with an artificial-intelligence-based algorithm.

In a further embodiment, which can be combined with all other embodiments of the measurement application device mentioned above or below, the data processor may further be configured to automatically configure the measurement application device based on at last one of the unit, orientation, and scaling detected for the at least one axis.

Above, it is described how the data processor may fit the extracted graph into the displayed measurement signal. With the present embodiment, the data processor may also fit the measurement signal into the extracted graph, or a diagram comprising the extracted graph.

To this end, instead of moving, rotating, and scaling the extracted graph, the data processor may adapt the internal settings of the measurement application device, such that the acquisition and/or displaying of the measurement signal is adapted to the extracted graph.

In embodiments, a user may choose if the extracted graph is fitted into the display of the measurement signal, or vice versa.

In further embodiments, the data processor may move, rotate, and scale the extracted graph, at least such that the extracted graph may be fitted on the display of the measurement application device, and such that at least one of the axes of the extracted graph is horizontally oriented, and/or the other axis is vertically oriented. The data processor may then fit the measurement data into this preprocessed extracted graph.

In another embodiment, which can be combined with all other embodiments of the measurement application device mentioned above or below, the data processor may further be configured to compare the measurement signal with the extracted graph, and to output a pass/fail signal based on predefined pass/fail criteria. The pass/fail signal may be provided as any one of, but is not limited to, an indication for a user on a screen, a discrete analog or digital signal, data over a digital interface e.g., in an SCPI command or SCPI data packet.

The pass/fail criteria may be provided by a user for automatically comparing the measurement signal with the extracted graph. A positive pass/fail signal that indicates a passed test may e.g., be provided if the comparison fulfills all the pass/fail criteria.

The pass/fail criteria may e.g., comprise a minimum value for a similarity measure that may be calculated between the measurement signal, and the extracted graph. In another embodiment, the pass/fail criteria may e.g., comprise a maximum value for a dissimilarity measure that may be calculated between the measurement signal, and the extracted graph. A combination of both is possible.

In an embodiment, the dissimilarity measure may e.g., comprise the distance between the extracted graph, and a graph representing the measurement signal. A user may in such an embodiment, define a maximum distance that is allowed in order to still pass the test. If for no point on the horizontal axis, the distance on the vertical axis is larger than the user-defined maximum distance, the test may be indicated as passed.

In another embodiment, the predefined pass/fail criteria may refer to a measurement signal reaching or traversing the extracted graph either from above or below. In such an embodiment, a fail signal may be output i.e., the test may be indicated as failed, if the measurement signal reaches or traverses the extracted graph either from above or from below.

In an embodiment, which can be combined with all other embodiments of the measurement application device mentioned above or below, the data processor may further be configured to perform predefined mathematical calculations with the measurement signal, and the extracted graph, and output a result of the predefined mathematical calculations.

The data processor may perform any possible mathematical calculations with the extracted graph, and the measurement signal, like filtering, smoothing, and averaging.

The data processor may e.g., calculate a difference between the measurement signal, and the extracted graph, or vice versa. The result of this calculation may be shown e.g., as additional graph or curve on the display of the measurement application device.

The user may, therefore, easily visually inspect the measurement signal compared to the extracted graph.

In embodiments, the result of the predefined mathematical calculations may be output as value, especially as absolute value or as percentage. For graphs that represent more than a single measurement point, the maximum and minimum values may be output.

In a further embodiment, which can be combined with all other embodiments of the measurement application device mentioned above or below, the data processor may further be configured to select one of a plurality of measurement signals for further processing with the extracted graph.

Modern measurement application devices may measure multiple signals or process multiple measurement signals at the same time.

In such embodiments, a user may be provided with the option to select e.g., via the user interface of the measurement application device, the measurement signal that is to be processed together with the extracted graph.

The expression "to be processed" in this regard refers to any of the operations mentioned in this disclosure, that require common processing or common operations on the extracted graph, and the measurement signal.

In another embodiment, which can be combined with all other embodiments of the measurement application device mentioned above or below, if the graphical data comprises multiple graphs, or if multiple sets of graphical data are provided, the data processor may further be configured to allow a user to select one of the available graphs for further processing.

As with multiple measurement signals, the user may also be presented with a list of the available graphs. In embodiments, the data processor may extract all available graphs and show them to a user for selection of the relevant graph.

The expression "for further processing" in this regard refers to any of the operations mentioned in this disclosure, that require processing or operating on the extracted graph alone or with the measurement signal.

A user may also be provided with the option of storing extracted graphs for later use in another measurement application. To this end, the user may also provide a description for each one of the extracted graphs.

The extracted graphs may be stored locally in the measurement application device. In other embodiments, the extracted graphs may be stored in a central server or a cloud storage for later use by multiple measurement application devices.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a measurement application device according to the present disclosure;
Figure 2 shows a block diagram of another embodiment of a measurement application device according to the present disclosure;
Figure 3 shows a block diagram of another embodiment of a measurement application device according to the present disclosure;
Figure 4 shows a block diagram of another embodiment of a measurement application device according to the present disclosure;
Figure 5 shows a flow diagram of an embodiment of a method according to the present disclosure;
Figure 6 shows a flow diagram of another embodiment of a method according to the present disclosure;
Figure 7 shows a flow diagram of another embodiment of a method according to the present disclosure;
Figure 8 shows a flow diagram of another embodiment of a method according to the present disclosure;
Figure 9 shows a block diagram of an oscilloscope as a possible embodiment of a measurement application device according to the present disclosure;
Figure 10 shows a block diagram of another oscilloscope as a possible embodiment of a measurement application device according to the present disclosure;

In the figures like reference signs denote like elements unless stated otherwise.

### DETAILED DESCRIPTION OF THE DRAWINGS

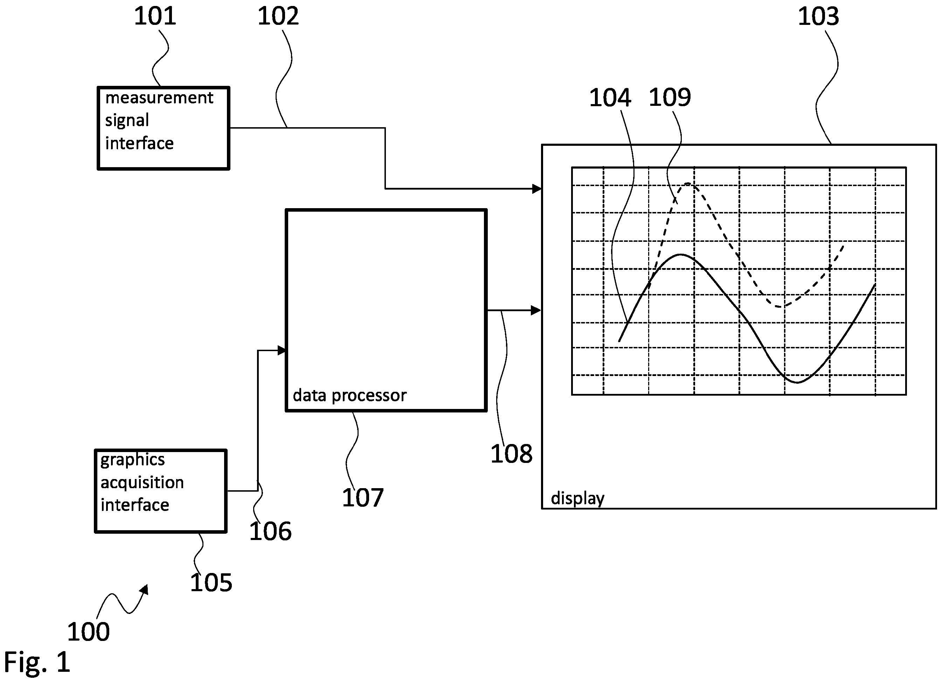

Figure 1 shows a block diagram of a measurement application device 100. The measurement application device 100 comprises a measurement signal interface 101 that is coupled to a display 103. The measurement application device 100 further comprises a graphics acquisition interface 105 that is coupled to a data processor 107 that is also coupled to the display 103.

The measurement signal interface 101 acquires a measurement signal 102. The measurement signal 102 may be the signal as recorded by the measurement application device 100 from a device under test or DUT, which is not explicitly shown in figure 1. In such an embodiment, the measurement signal interface 101 may be implemented as a measurement frontend of the measurement application device 100.

The measurement signal 102 may also be a digital signal that comprises data as measured by another measurement application device. In such an embodiment, the measurement signal interface 101 may be implemented as a network or data interface. The measurement application device 100 in such an embodiment may be a hardware-based measurement device, like an oscilloscope, or a software-based measurement application device, like an application that is executed on a user's computer, or a website or web-application.

The acquired measurement signal 102 is then displayed on the display 103 in the form of the measurement signal graph 104. Depending on the embodiment of the measurement application device 100, the display 103 may be the display of a hardware-based measurement device, like an oscilloscope, or a software-based measurement application device, like an application that is executed on a user's computer, or a website or web-application.

The graphics acquisition interface 105 acquires graphical data 106. The graphical data 106 comprises a graphical representation of a graph, for example, a graph 108 showing a characteristic curve or trace 109 e.g., for the device under test. Such a characteristic curve may be provided e.g., in a datasheet. Generally, the graphical data 106 may be provided as any kind of graphical data, for example, as graphics file or as document, like a PDF document.

The data processor 107 receives the graphical data 106, and extracts the graph 108 from the graphical data 106. The data processor 107 may control the display 103 to show the extracted graph 108 with the measurement signal 102. In the display 103, not the entire extracted graph 108 e.g., with diagram axes, is shown. Instead, only the characteristic curve 109 comprised in the extracted graph 108 is shown on the display.

Although not shown in figure 1, the data processor 107 may extract at least one of a unit of at least one coordinate system axis of a coordinate system comprising the graph 108, and a value range of the at least one coordinate system axis, and a scaling of the at least one coordinate system axis from the graphical data 106. With this information at hand, the data processor 107 may automatically configure the measurement application device 100 based on at last one of the unit, orientation, and scaling detected for the at least one axis. The data processor 107 may e.g., configure the measurement application device 100 such that the scaling, rotation, or value range of the measurement signal graph 204 matches that of the trace 109.

In embodiments, the data processor 107 may select one of a plurality of measurement signals 102 for further processing with the extracted graph 108, if multiple measurement signals 102 are provided. Of course, the data processor 107 may also receive a user input for selecting one of the measurement signals 102.

If the graphical data 106 comprises multiple graphs 108, or if multiple sets of graphical data 106 are provided, the data processor 107 may further allow a user to select one of the available graphs 108 for further processing.

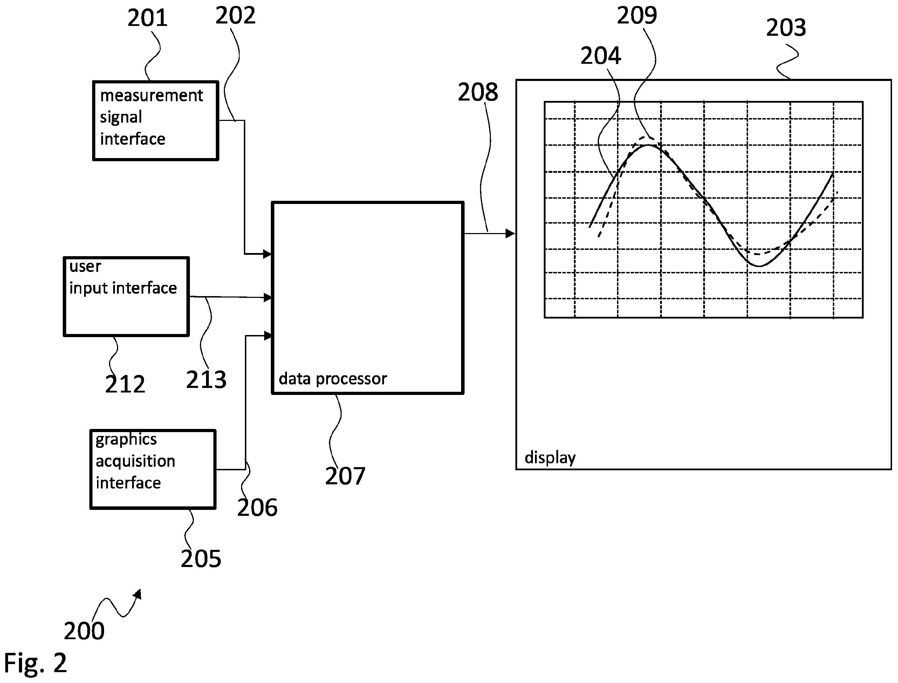

Figure 2 shows a block diagram of a measurement application device 200. The measurement application device 200 is based on the measurement application device 100. Consequently, the measurement application device 200 comprises a measurement signal interface 201 that is coupled to a data processor 207. The measurement application device 200 further comprises a graphics acquisition interface 205 that is coupled to the data processor 207 that is also coupled to a display 203. The explanations provided above regarding the measurement application device 100 apply to the measurement application device 200 mutatis mutandis. Further, the features of the measurement application device 200 may combined with any one of the features of any other embodiment of the measurement application device described herein.

The measurement application device 200 further comprises a user input interface 212 that serves for acquiring a user input 213, and providing the user input 213 to the data processor 207.

The user input interface 212 may comprise an interface of a hardware-based measurement application device 200, like a touchscreen of an oscilloscope, and buttons and switches of said measurement application device 200. In software-based embodiments of the measurement application device 200, the user input interface 212 may comprise user input elements on a graphical user interface of the respective application of website.

The user input 213 may in embodiments comprise input regarding at least one of the units of one or more, especially two, coordinate system axes of a coordinate system comprising the graph 208, a value range of the one or more coordinate system axes, and a scaling of the one or more coordinate system axes. Alternatively, or in addition, the data processor 207 may extract such data automatically from the graphical data 206 or the graph 208.

The data processor 207 may then adapt the displaying of the extracted graph 208 according to the received or extracted information. In order to match e.g., the displaying of the graph 208, and the measurement data 202, the information from the measurement signal interface 202 is fed through the data processor 207. As can be seen in the display 203, the trace 209, in contrast to trace 109 in figure 1, is adapted by the data processor 207 to match the position, rotation and scaling of the measurement signal graph 204.

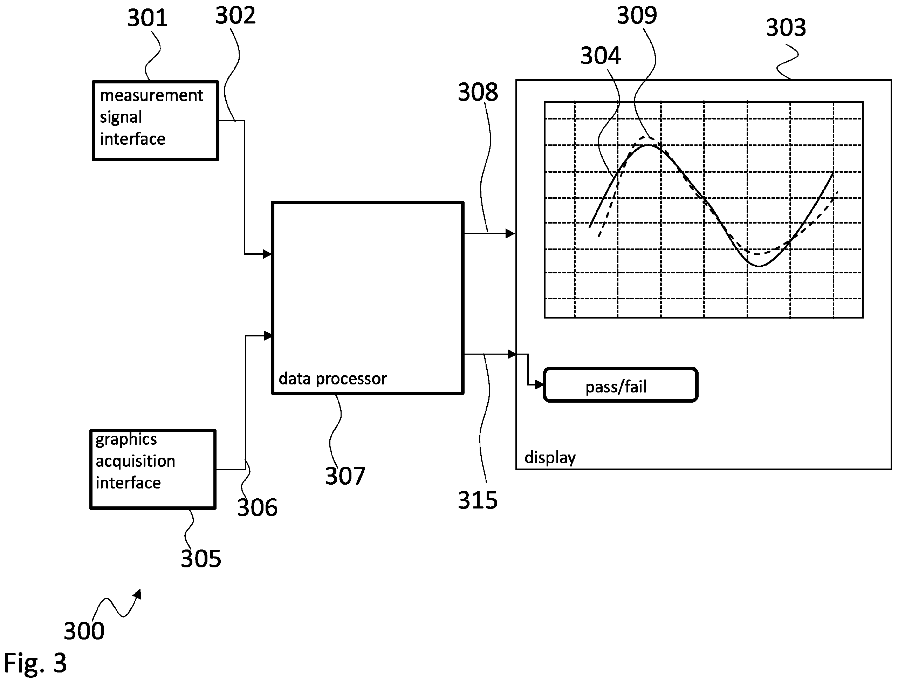

Figure 3 shows a block diagram of a measurement application device 300. The measurement application device 300 is based on the measurement application device 100. Consequently, the measurement application device 300 comprises a measurement signal interface 301 that is coupled to the data processor 307. The measurement application device 300 further comprises a graphics acquisition interface 305 that is coupled to the data processor 307 that is also coupled to a display 303. The explanations provided above regarding the measurement application device 100 apply to the measurement application device 300 mutatis mutandis. Further, the features of the measurement application device 300 may combined with any one of the features of any other embodiment of the measurement application device described herein.

In the display 303 of the measurement application device 300, a pass/fail indication is provided based on a pass/fail signal 315. This pass/fail signal 315 may be generated by the data processor 307 based e.g., on predefined pass/fail criteria. Such pass/fail criteria may be provided by a user e.g., via a user interface, or may be predefined in the measurement application device 300. In further embodiments, the measurement application device 300 may also be automatically derived from the measurement signal 302, and the graphical data 306.

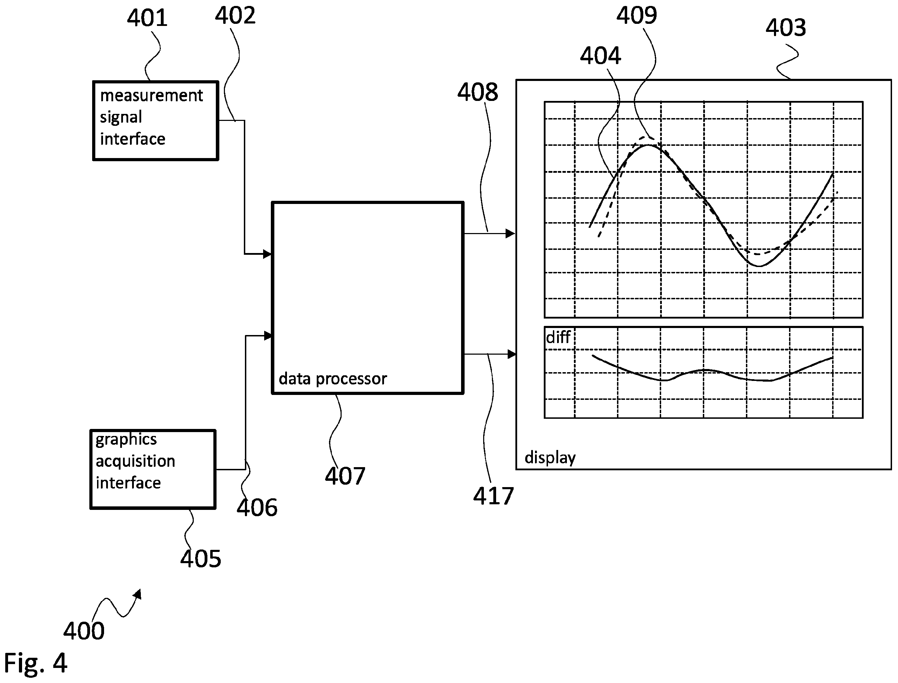

Figure 4 shows a block diagram of a measurement application device 400. The measurement application device 400 is based on the measurement application device 100. Consequently, the measurement application device 400 comprises a measurement signal interface 401 that is coupled to the data processor 407. The measurement application device 400 further comprises a graphics acquisition interface 405 that is coupled to the data processor 407 that is also coupled to the display 403. The explanations provided above regarding the measurement application device 100 apply to the measurement application device 400 mutatis mutandis. Further, the features of the measurement application device 400 may combined with any one of the features of any other embodiment of the measurement application device described herein.

The data processor 407 of the measurement application device 400 receives the measurement signal 402 from the measurement signal interface 401. With this information, the graphics acquisition interface 405 may calculate predefined mathematical functions or perform predefined mathematical calculations with the graphical data 406, and the measurement signal 402.

In the exemplary measurement application device 400, the data processor 407 calculates a difference between the measurement signal graph 404, and the trace 409. The data processor 407 displays the calculated difference in a second diagram, that is shown below the diagram showing the measurement signal graph 404, and the trace 409.

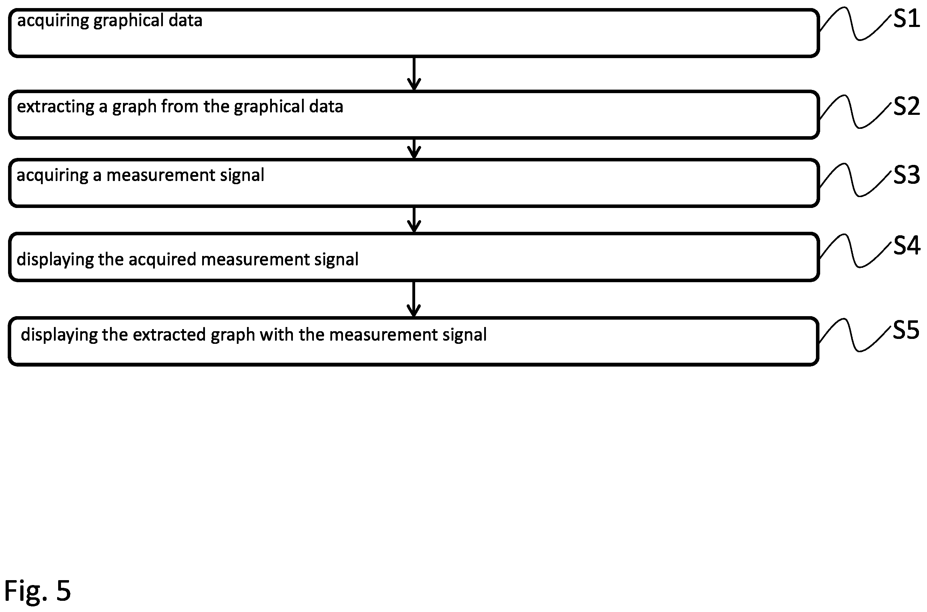

For sake of clarity in the following description of the method-based figures 5 - 8 the reference signs used above in the description of apparatus-based figures. 1 - 4 will be maintained.

Figure 5 shows a flow diagram of a method for operating a measurement application device 100, 200, 300, 400, OSC1, OSC.

The method comprises acquiring S1 graphical data 106, 206, 306, 406, extracting S2 a graph 108, 208, 308, 408 from the graphical data 106, 206, 306, 406, acquiring S3 a measurement signal 102, 202, 302, 402, displaying S4 the acquired measurement signal 102, 202, 302, 402, and displaying S5 the extracted graph 108, 208, 308, 408 with the measurement signal 102, 202, 302, 402.

Although not explicitly shown, the method may also comprise selecting one of a plurality of measurement signals 102, 202, 302, 402 for further processing with the extracted graph 108, 208, 308, 408. If the graphical data 106, 206, 306, 406 comprises multiple graphs 108, 208, 308, 408, or if multiple sets of graphical data 106, 206, 306, 406 are provided, the method may further comprise receiving a user selection of a user to select one of the available graphs 108, 208, 308, 408 for further processing.

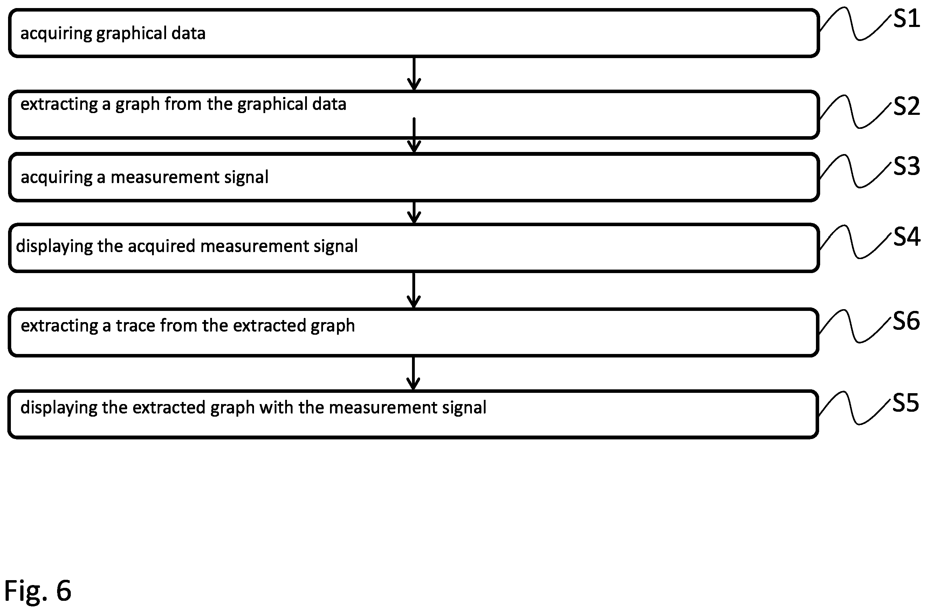

Figure 6 shows a flow diagram of another method for operating a measurement application device 100, 200, 300, 400, OSC1, OSC. The method of figure 6 is based on the method of figure 5. The method of figure 6, therefore, comprises acquiring S1 graphical data 106, 206, 306, 406, extracting S2 a graph 108, 208, 308, 408 from the graphical data 106, 206, 306, 406, acquiring S3 a measurement signal 102, 202, 302, 402, displaying S4 the acquired measurement signal 102, 202, 302, 402, and displaying S5 the extracted graph 108, 208, 308, 408 with the measurement signal 102, 202, 302, 402. The explanations provided regarding the method of figure 5 apply mutatis mutandis to the method of figure 6. Further, any one of the features of the other embodiments of the method explained herein may be combined with the method according to figure 6.

Further, the method of figure 6 comprises after extracting S3 the graph, extracting S6 a trace 109, 209, 309, 409 of the graph 108, 208, 308, 408 from the graphical data 106, 206, 306, 406. Wherein the trace 109, 209, 309, 409 is then displayed.

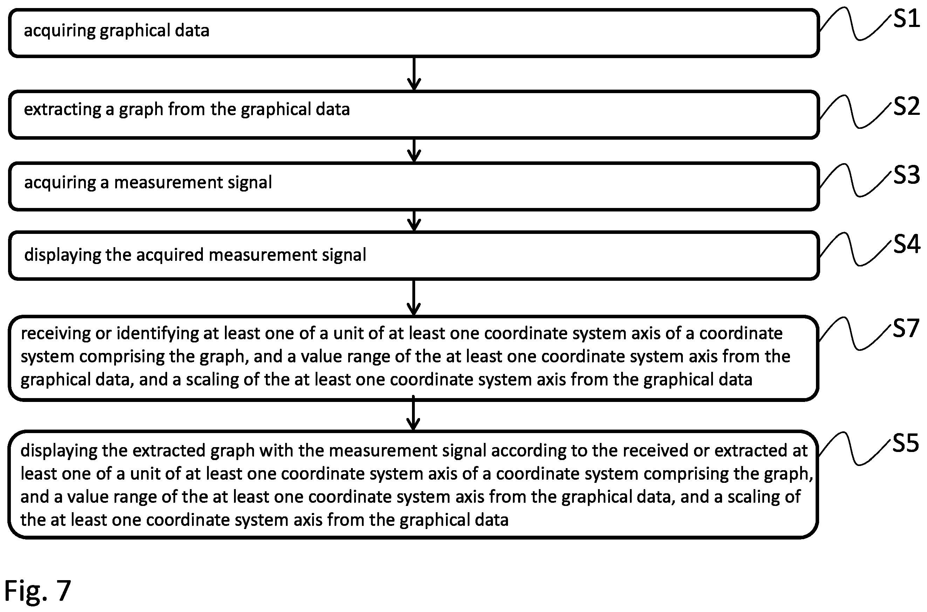

Figure 7 shows a flow diagram of another method for operating a measurement application device 100, 200, 300, 400, OSC1, OSC. The method of figure 7 is based on the method of figure 5. The method of figure 7, therefore, comprises acquiring S1 graphical data 106, 206, 306, 406, extracting S2 a graph 108, 208, 308, 408 from the graphical data 106, 206, 306, 406, acquiring S3 a measurement signal 102, 202, 302, 402, displaying S4 the acquired measurement signal 102, 202, 302, 402, and displaying S5 the extracted graph 108, 208, 308, 408 with the measurement signal 102, 202, 302, 402. The explanations provided regarding the method of figure 5 apply mutatis mutandis to the method of figure 7. Further, any one of the features of the other embodiments of the method explained herein may be combined with the method according to figure 7.

The method of figure 7 further comprises receiving or automatically extracting or identifying S7 at least one of a unit of at least one coordinate system axis of a coordinate system comprising the graph 108, 208, 308, 408, and a value range of the at least one coordinate system axis from the graphical data 106, 206, 306, 406, and a scaling of the at least one coordinate system axis from the graphical data 106, 206, 306, 406.

The displaying of the extracted graph 108, 208, 308, 408 is then amended according to the received at least one of a unit of at least one coordinate system axis of a coordinate system comprising the graph 108, 208, 308, 408, and a value range of the at least one coordinate system axis, and a scaling of the at least one coordinate system axis.

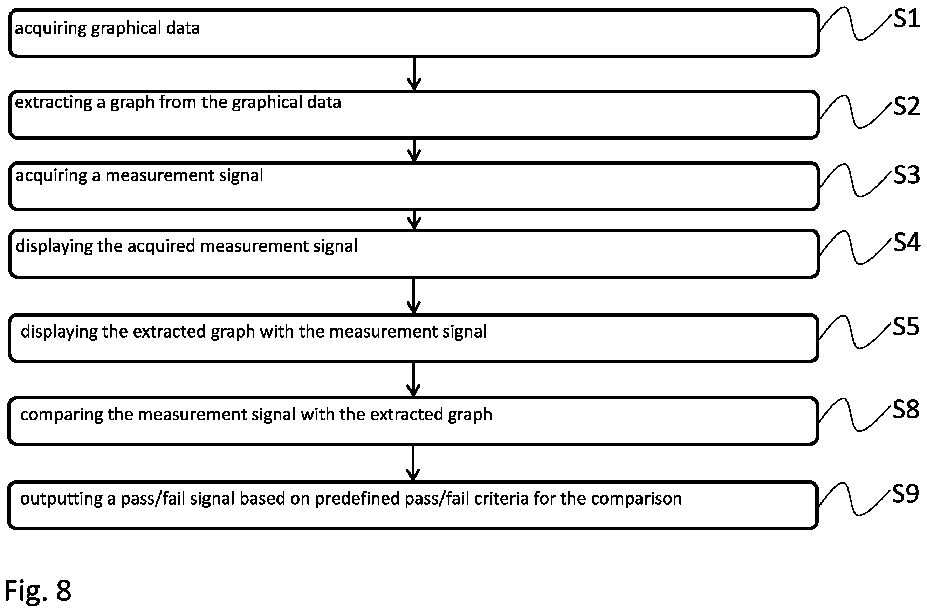

Figure 8 shows a flow diagram of another method for operating a measurement application device 100, 200, 300, 400, OSC1, OSC. The method of figure 8 is based on the method of figure 5. The method of figure 8, therefore, comprises acquiring S1 graphical data 106, 206, 306, 406, extracting S2 a graph 108, 208, 308, 408 from the graphical data 106, 206, 306, 406, acquiring S3 a measurement signal 102, 202, 302, 402, displaying S4 the acquired measurement signal 102, 202, 302, 402, and displaying S5 the extracted graph 108, 208, 308, 408 with the measurement signal 102, 202, 302, 402. The explanations provided regarding the method of figure 5 apply mutatis mutandis to the method of figure 8. Further, any one of the features of the other embodiments of the method explained herein may be combined with the method according to figure 8.

The method of figure 8 further comprises comparing S8 the measurement signal 102, 202, 302, 402 with the extracted graph 108, 208, 308, 408, and outputting S9 a pass/fail signal 315 based on predefined pass/fail criteria.

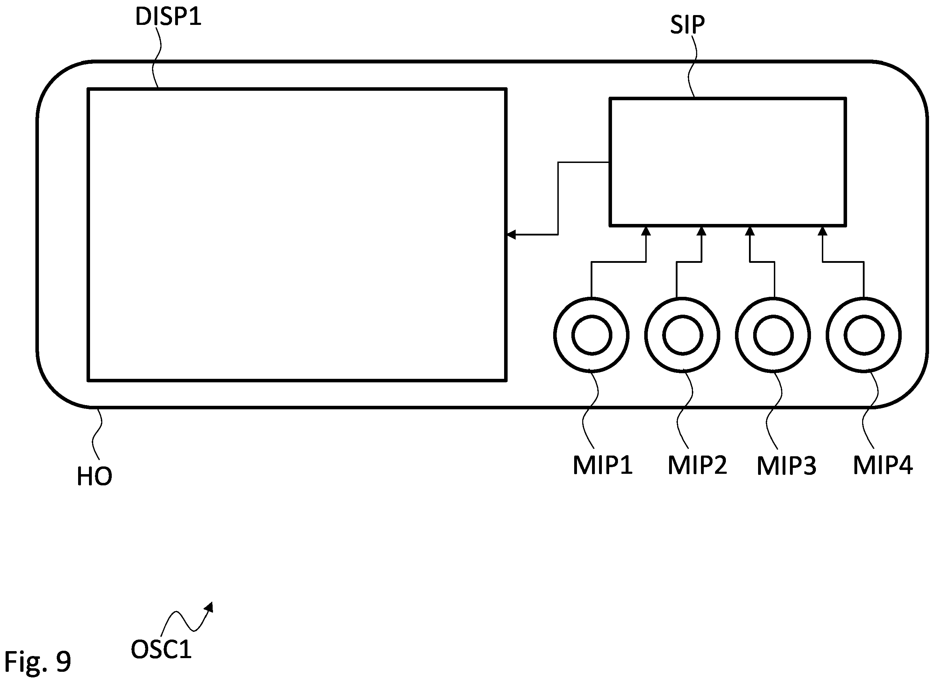

Figure 9 shows a block diagram of an oscilloscope OSC1 that may be used with an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

Although not explicitly shown, it is understood, that the oscilloscope OSC1 may also comprise signal outputs that may also be coupled to the differential measurement probe. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In the oscilloscope OSC1 the signal processor SIP or an additional processing element may perform the function of measurement application device according to the present disclosure, or may implement the measurement application device or the method. Of course, a communication interface may be provided in the oscilloscope OSC1 for communication with other measurement application devices.

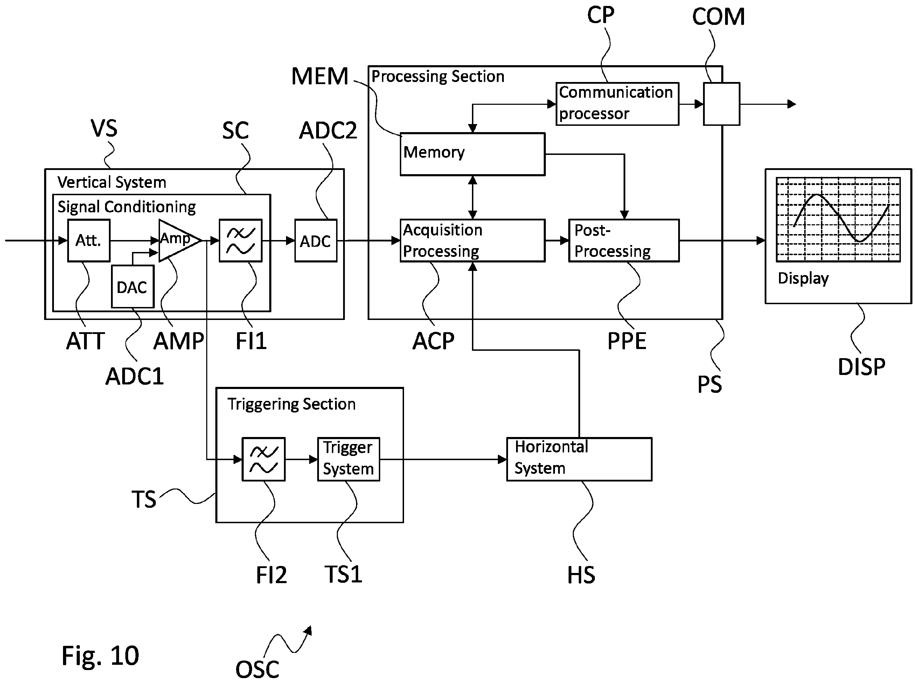

Figure 10 shows a block diagram of an oscilloscope OSC that may be an implementation of a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS, and the display DISP. It is understood, that the partitioning into five general sections is a logical partitioning and does not limit the placement and implementation of any of the elements of the oscilloscope OSC in any way.

The vertical system VS mainly serves for offsetting, attenuating, and amplifying a signal to be acquired. The signal may for example be modified to fit in the available space on the display DISP or to comprise a vertical size as configured by a user.

To this end, the vertical system VS comprises a signal conditioning section SC with an attenuator ATT and a digital-to-analog-converter DAC that are coupled to an amplifier AMP1. The amplifier AMP1 is coupled to a filter Fl1, which in the shown example is provided as a low pass filter. The vertical system VS also comprises an analog-to-digital converter ADC1 that receives the output from the filter Fl1 and converts the received analog signal into a digital signal.

The attenuator ATT and the amplifier AMP1 serve to scale the amplitude of the signal to be acquired to match the operation range of the analog-to-digital converter ADC1. The digital-to-analog-converter DAC1 serves to modify the DC component of the input signal to be acquired to match the operation range of the analog-to-digital converter ADC1. The filter Fl1 serves to filter out unwanted high frequency components of the signal to be acquired.

The triggering section TS operates on the signal as provided by the amplifier AMP. The triggering section TS comprises a filter Fl2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be provided for the analog-to-digital converter ADC1 and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the amplifier AMP but will operate on the digital signal as provided by the analog-to-digital converter ADC1.

A digital triggering section may comprise a processing element, like a processor, a DSP, a CPLD, an ASIC or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC1 and the output of the horizontal system HS as well as to a memory MEM and a post processing element PPE.

The acquisition processing element ACP manages the acquisition of digital data from the analog-to-digital converter ADC1 and the storage of the data in the memory MEM. The acquisition processing element ACP may for example comprise a processing element with a digital interface to the analog-to-digital converter ADC2 and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infra-red communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

In the oscilloscope OSC, any one of the processing elements in the processing section PS or an additional processing element may perform the function measurement application device or the method according to the present disclosure.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software, and firmware components.

While exemplary embodiments are described above, it is not intended that these embodiments describe all possible forms encompassed by the claims. The words used in the specification are words of description rather than limitation, and it is understood that various changes can be made without departing from the scope of the disclosure. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

### LIST OF REFERENCE SIGNS

- 100, 200, 300, 400: measurement application device
- 101, 201, 301, 401: measurement signal interface
- 102, 202, 302, 402: measurement signal
- 103, 203, 303, 403: display
- 104, 204, 304, 404: measurement signal graph
- 105, 205, 305, 405: graphics acquisition interface
- 106, 206, 306, 406: graphical data
- 107, 207, 307, 407: data processor
- 108, 208, 308, 408: graph
- 109, 209, 309, 409: trace

- 212: user input interface
- 213: user input

- 315: pass/fail signal

- 417: result

- OSC1: oscilloscope
- HO: housing
- MIP1, MIP2, MIP3, MIP4: measurement input
- SIP: signal processing
- DISP1: display

- OSC: oscilloscope
- VS: vertical system
- SC: signal conditioning
- ATT: attenuator
- DAC1: analog-to-digital converter
- AMP1: amplifier
- Fl1: filter
- ADC1: analog-to-digital converter
- TS: triggering section
- AMP2: amplifier
- Fl2: filter
- TS1: trigger system

- HS: horizontal system

- PS: processing section
- ACP: acquisition processing element
- MEM: memory
- PPE: post processing element

- DISP: display

- S1 - S9: method steps

## Claims

1. Measurement application device (100, 200, 300, 400, OSC1, OSC) comprising:
a measurement signal interface (101, 201, 301, 401) configured to acquire a measurement signal (102, 202, 302, 402);
a display (103, 203, 303, 403, DISP1, DISP) coupled to the measurement signal interface (101, 201, 301, 401), and configured to display the acquired measurement signal (102, 202, 302, 402);
a graphics acquisition interface (105, 205, 305, 405) configured to acquire graphical data (106, 206, 306, 406) that comprises a graphical representation of a graph;
a data processor (107, 207, 307, 407) coupled to the graphics acquisition interface (105, 205, 305, 405) and the display (103, 203, 303, 403, DISP1, DISP), and configured to extract the graph (108, 208, 308, 408) from the graphical data (106, 206, 306, 406), and to display the extracted graph (108, 208, 308, 408) with the measurement signal (102, 202, 302, 402) on the display (103, 203, 303, 403, DISP1, DISP).

2. Measurement application device (100, 200, 300, 400, OSC1, OSC) according to claim 1, wherein the data processor (107, 207, 307, 407) is further configured to extract a trace (109, 209, 309, 409) of the graph (108, 208, 308, 408) from the graphical data (106, 206, 306, 406).

3. Measurement application device (100, 200, 300, 400, OSC1, OSC) according to any one of the preceding claims, further comprising a user input interface (212) configured to receive at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406); and
wherein the data processor (107, 207, 307, 407) is further configured to adapt the displaying of the extracted graph (108, 208, 308, 408) according to the received at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406).

4. Measurement application device (100, 200, 300, 400, OSC1, OSC) according to any one of the preceding claims, wherein the data processor (107, 207, 307, 407) is further configured to extract at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406).

5. Measurement application device (100, 200, 300, 400, OSC1, OSC) according to claim 4, wherein the data processor (107, 207, 307, 407) is further configured to adapt the displaying of the extracted graph (108, 208, 308, 408) according to the extracted at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406).

6. Measurement application device (100, 200, 300, 400, OSC1, OSC) according to any one of claims 4 and 5, wherein the data processor (107, 207, 307, 407) is further configured to automatically configure the measurement application device (100, 200, 300, 400, OSC1, OSC) based on at last one of the unit, orientation, and scaling detected for the at least one axis.

7. Measurement application device (100, 200, 300, 400, OSC1, OSC) according to any one of the preceding claims, wherein the data processor (107, 207, 307, 407) is further configured to compare the measurement signal (102, 202, 302, 402) with the extracted graph (108, 208, 308, 408), and to output a pass/fail signal (315) based on predefined pass/fail criteria.

8. Measurement application device (100, 200, 300, 400, OSC1, OSC) according to any one of the preceding claims, wherein the data processor (107, 207, 307, 407) is further configured to perform predefined mathematical calculations with the measurement signal (102, 202, 302, 402), and the extracted graph (108, 208, 308, 408), and output a result (417) of the predefined mathematical calculations.

9. Measurement application device (100, 200, 300, 400, OSC1, OSC) according to any one of the preceding claims, wherein the data processor (107, 207, 307, 407) is further configured to select at least one of a plurality of measurement signals (102, 202, 302, 402) for further processing with the extracted graph (108, 208, 308, 408).

10. Measurement application device (100, 200, 300, 400, OSC1, OSC) according to any one of the preceding claims, wherein, if the graphical data (106, 206, 306, 406) comprises multiple graphs (108, 208, 308, 408), or if multiple sets of graphical data (106, 206, 306, 406) are provided, the data processor (107, 207, 307, 407) is further configured to allow a user to select at least one of the available graphs (108, 208, 308, 408) for further processing.

11. Computer implemented method for operating a measurement application device (100, 200, 300, 400, OSC1, OSC), the method comprising:
acquiring (S1) graphical data (106, 206, 306, 406) that comprises a graphical representation of a graph;
extracting (S2) the graph (108, 208, 308, 408) from the graphical data (106, 206, 306, 406);
acquiring (S3) a measurement signal (102, 202, 302, 402);
displaying (S4) the acquired measurement signal (102, 202, 302, 402); and
displaying (S5) the extracted graph (108, 208, 308, 408) with the measurement signal (102, 202, 302, 402).

12. Computer implemented method for operating a measurement application device (100, 200, 300, 400, OSC1, OSC) according to claim 11, further comprising extracting a trace (109, 209, 309, 409) of the graph (108, 208, 308, 408) from the graphical data (106, 206, 306, 406).

13. Computer implemented method for operating a measurement application device (100, 200, 300, 400, OSC1, OSC) according to claims 11 or 12, further comprising receiving at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406); and
adapting the displaying of the extracted graph (108, 208, 308, 408) according to the received at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406).

14. Computer implemented method for operating a measurement application device (100, 200, 300, 400, OSC1, OSC) according to any one of claims 11 to 13, further comprising extracting at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406).

15. Computer implemented method for operating a measurement application device (100, 200, 300, 400, OSC1, OSC) according to claim 14, further comprising automatically adapting the displaying of the extracted graph (108, 208, 308, 408) according to the extracted at least one of a unit of at least one coordinate system axis of a coordinate system comprising the graph (108, 208, 308, 408), and a value range of the at least one coordinate system axis, and a scaling of the at least one coordinate system axis from the graphical data (106, 206, 306, 406).

16. Computer implemented method for operating a measurement application device (100, 200, 300, 400, OSC1, OSC) according to any one of claims 14 and 15, further comprising automatically configuring the measurement application device (100, 200, 300, 400, OSC1, OSC) based on at last one of the unit, orientation, and scaling detected for the at least one axis.

17. Computer implemented method for operating a measurement application device (100, 200, 300, 400, OSC1, OSC) according to any one of claims 11 to 16, further comprising comparing the measurement signal (102, 202, 302, 402) with the extracted graph (108, 208, 308, 408); and outputting a pass/fail signal (315) based on predefined pass/fail criteria.

18. Computer implemented method for operating a measurement application device (100, 200, 300, 400, OSC1, OSC) according to any one of claims 11 to 17, further comprising performing predefined mathematical calculations with the measurement signal (102, 202, 302, 402), and the extracted graph (108, 208, 308, 408);
outputting a result (417) of the predefined mathematical calculations.

19. Computer implemented method for operating a measurement application device (100, 200, 300, 400, OSC1, OSC) according to any one of claims 11 to18, further comprising selecting at least one of a plurality of measurement signals (102, 202, 302, 402) for further processing with the extracted graph (108, 208, 308, 408).

20. Computer implemented method for operating a measurement application device (100, 200, 300, 400, OSC1, OSC) according to any one of claims 11 to 19, further comprising, if the graphical data (106, 206, 306, 406) comprises multiple graphs (108, 208, 308, 408), or if multiple sets of graphical data (106, 206, 306, 406) are provided, receiving a user selection of a user to select at least one of the available graphs (108, 208, 308, 408) for further processing.

21. A computer program product comprising instructions which, when the program is executed by a computer, cause the computer to carry out the steps of the method according to any one of claims 11 to 20.

## Patentansprüche

1. Messanwendungsvorrichtung (100, 200, 300, 400, OSC1, OSC), umfassend:
eine Messsignalschnittstelle (101, 201, 301, 401), die konfiguriert ist, um ein Messsignal (102, 202, 302, 402) zu erfassen;
eine Anzeige (103, 203, 303, 403, DISP1, DISP), die an die Messsignalschnittstelle (101, 201, 301, 401) gekoppelt ist und konfiguriert ist, um das erfasste Messsignal (102, 202, 302, 402) anzuzeigen;
eine Grafikerfassungsschnittstelle (105, 205, 305, 405), die konfiguriert ist, um grafische Daten (106, 206, 306, 406) zu erfassen, die eine grafische Darstellung eines Graphen umfassen;
einen Datenprozessor (107, 207, 307, 407), der an die Grafikerfassungsschnittstelle (105, 205, 305, 405) und die Anzeige (103, 203, 303, 403, DISP1, DISP) gekoppelt ist und konfiguriert ist, um den Graphen (108, 208, 308, 408) aus den grafischen Daten (106, 206, 306, 406) zu extrahieren und um den extrahierten Graphen (108, 208, 308, 408) mit dem Messsignal (102, 202, 302, 402) auf der Anzeige (103, 203, 303, 403, DISP1, DISP) anzuzeigen.

2. Messanwendungsvorrichtung (100, 200, 300, 400, OSC1, OSC) nach Anspruch 1, wobei der Datenprozessor (107, 207, 307, 407) ferner konfiguriert ist, um eine Spur (109, 209, 309, 409) des Graphen (108, 208, 308, 408) aus den grafischen Daten (106, 206, 306, 406) zu extrahieren.

3. Messanwendungsvorrichtung (100, 200, 300, 400, OSC1, OSC) nach einem der vorstehenden Ansprüche, ferner umfassend eine Benutzereingabeschnittstelle (212), die konfiguriert ist, um mindestens eines von einer Einheit mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406) zu empfangen; und
wobei der Datenprozessor (107, 207, 307, 407) ferner konfiguriert ist, um das Anzeigen des extrahierten Graphen (108, 208, 308, 408) gemäß dem empfangenen mindestens einen von einer Einheit mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406) anzupassen.

4. Messanwendungsvorrichtung (100, 200, 300, 400, OSC1, OSC) nach einem der vorstehenden Ansprüche, wobei der Datenprozessor (107, 207, 307, 407) ferner konfiguriert ist, um mindestens eines von einer Einheit mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406) zu extrahieren.

5. Messanwendungsvorrichtung (100, 200, 300, 400, OSC1, OSC) nach Anspruch 4, wobei der Datenprozessor (107, 207, 307, 407) ferner konfiguriert ist, um das Anzeigen des extrahierten Graphen (108, 208, 308, 408) gemäß dem extrahierten mindestens einen von einer Einheit mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406) anzupassen.

6. Messanwendungsvorrichtung (100, 200, 300, 400, OSC1, OSC) nach einem der Ansprüche 4 und 5, wobei der Datenprozessor (107, 207, 307, 407) ferner konfiguriert ist, um die Messanwendungsvorrichtung (100, 200, 300, 400, OSC1, OSC) basierend auf mindestens einer von der Einheit, der Ausrichtung und der Skalierung automatisch zu konfigurieren, die für die mindestens eine Achse erkannt wird.

7. Messanwendungsvorrichtung (100, 200, 300, 400, OSC1, OSC) nach einem der vorstehenden Ansprüche, wobei der Datenprozessor (107, 207, 307, 407) ferner konfiguriert ist, um das Messsignal (102, 202, 302, 402) mit dem extrahierten Graphen (108, 208, 308, 408) zu vergleichen und um basierend auf vordefinierten Pass/Fail-Kriterien ein Pass/Fail-Signal (315) auszugeben.

8. Messanwendungsvorrichtung (100, 200, 300, 400, OSC1, OSC) nach einem der vorstehenden Ansprüche, wobei der Datenprozessor (107, 207, 307, 407) ferner konfiguriert ist, um vordefinierte mathematische Berechnungen mit dem Messsignal (102, 202, 302, 402) und dem extrahierten Graphen (108, 208, 308, 408) durchzuführen und ein Ergebnis (417) der vordefinierten mathematischen Berechnungen auszugeben.

9. Messanwendungsvorrichtung (100, 200, 300, 400, OSC1, OSC) nach einem der vorstehenden Ansprüche, wobei der Datenprozessor (107, 207, 307, 407) ferner konfiguriert ist, um mindestens eines von einer Vielzahl von Messsignalen (102, 202, 302, 402) für eine weitere Verarbeitung mit dem extrahierten Graphen (108, 208, 308, 408) auszuwählen.

10. Messanwendungsvorrichtung (100, 200, 300, 400, OSC1, OSC) nach einem der vorstehenden Ansprüche, wobei, falls die grafischen Daten (106, 206, 306, 406) mehrere Graphen (108, 208, 308, 408) umfassen, oder falls mehrere Sätze von grafischen Daten (106, 206, 306, 406) bereitgestellt werden, der Datenprozessor (107, 207, 307, 407) ferner konfiguriert ist, um es einem Benutzer zu ermöglichen, mindestens einen der verfügbaren Graphen (108, 208, 308, 408) für die weitere Verarbeitung auszuwählen.

11. Computerimplementiertes Verfahren zum Betreiben einer Messanwendungsvorrichtung (100, 200, 300, 400, OSC1, OSC), das Verfahren umfassend:
Erfassen (S1) grafischer Daten (106, 206, 306, 406), die eine grafische Darstellung eines Graphen umfassen;
Extrahieren (S2) des Graphen (108, 208, 308, 408) aus den grafischen Daten (106, 206, 306, 406);
Erfassen (S3) eines Messsignals (102, 202, 302, 402);
Anzeigen (S4) des erfassten Messsignals (102, 202, 302, 402); und
Anzeigen (S5) des extrahierten Graphen (108, 208, 308, 408) mit dem Messsignal (102, 202, 302, 402).

12. Computerimplementiertes Verfahren zum Betreiben einer Messanwendungsvorrichtung (100, 200, 300, 400, OSC1, OSC) nach Anspruch 11, ferner umfassend das Extrahieren einer Spur (109, 209, 309, 409) des Graphen (108, 208, 308, 408) aus den grafischen Daten (106, 206, 306, 406).

13. Computerimplementiertes Verfahren zum Betreiben einer Messanwendungsvorrichtung (100, 200, 300, 400, OSC1, OSC) nach den Ansprüchen 11 oder 12, ferner umfassend das Empfangen mindestens eines von einer Einheit von mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406); und
Anpassen des Anzeigens des extrahierten Graphen (108, 208, 308, 408) gemäß dem empfangenen mindestens einen von einer Einheit mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406).

14. Computerimplementiertes Verfahren zum Betreiben einer Messanwendungsvorrichtung (100, 200, 300, 400, OSC1, OSC) nach einem der Ansprüche 11 bis 13, ferner umfassend das Extrahieren mindestens eines von einer Einheit von mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406).

15. Computerimplementiertes Verfahren zum Betreiben einer Messanwendungsvorrichtung (100, 200, 300, 400, OSC1, OSC) nach Anspruch 14, ferner umfassend das automatische Anpassen des Anzeigens des extrahierten Graphen (108, 208, 308, 408) gemäß dem extrahierten mindestens einen von einer Einheit mindestens einer Koordinatensystemachse eines Koordinatensystems, umfassend den Graphen (108, 208, 308, 408), und einem Wertbereich der mindestens einen Koordinatensystemachse und einer Skalierung der mindestens einen Koordinatensystemachse aus den grafischen Daten (106, 206, 306, 406).

16. Computerimplementiertes Verfahren zum Betreiben einer Messanwendungsvorrichtung (100, 200, 300, 400, OSC1, OSC) nach einem der Ansprüche 14 und 15, ferner umfassend das automatische Konfigurieren der Messanwendungsvorrichtung (100, 200, 300, 400, OSC1, OSC) basierend auf mindestens einem von der Einheit, der Ausrichtung und der Skalierung, die für die mindestens eine Achse erkannt wird.

17. Computerimplementiertes Verfahren zum Betreiben einer Messanwendungsvorrichtung (100, 200, 300, 400, OSC1, OSC) nach einem der Ansprüche 11 bis 16, ferner umfassend das Vergleichen des Messsignals (102, 202, 302, 402) mit dem extrahierten Graphen (108, 208, 308, 408); und
Ausgeben eines Pass/Fail-Signals (315) basierend auf vordefinierten Pass/Fail-Kriterien.

18. Computerimplementiertes Verfahren zum Betreiben einer Messanwendungsvorrichtung (100, 200, 300, 400, OSC1, OSC) nach einem der Ansprüche 11 bis 17, ferner umfassend das Durchführen vordefinierter mathematischer Berechnungen mit dem Messsignal (102, 202, 302, 402) und dem extrahierten Graphen (108, 208, 308, 408);
Ausgeben eines Ergebnisses (417) der vordefinierten mathematischen Berechnungen.

19. Computerimplementiertes Verfahren zum Betreiben einer Messanwendungsvorrichtung (100, 200, 300, 400, OSC1, OSC) nach einem der Ansprüche 11 bis 18, ferner umfassend das Auswählen mindestens eines einer Vielzahl von Messsignalen (102, 202, 302, 402) zum weiteren Verarbeiten mit dem extrahierten Graphen (108, 208, 308, 408).

20. Computerimplementiertes Verfahren zum Betreiben einer Messanwendungsvorrichtung (100, 200, 300, 400, OSC1, OSC) nach einem der Ansprüche 11 bis 19, ferner umfassend, falls die grafischen Daten (106, 206, 306, 406) mehrere Graphen (108, 208, 308, 408) umfassen oder falls mehrere Sätze von grafischen Daten (106, 206, 306, 406) bereitgestellt werden, Empfangen einer Benutzerauswahl eines Benutzers, um mindestens einen der verfügbaren Graphen (108, 208, 308, 408) für die weitere Verarbeitung auszuwählen.

21. Computerprogrammprodukt, umfassend Anweisungen, die, wenn das Programm durch einen Computer durchgeführt wird, den Computer veranlassen, die Schritte des Verfahrens nach einem der Ansprüche 11 bis 20 auszuführen.

## Revendications

1. Dispositif d'application de mesure (100, 200, 300, 400, OSC1, OSC) comprenant :
une interface de signal de mesure (101, 201, 301,401) configurée pour acquérir un signal de mesure (102, 202, 302, 402) ;
un dispositif d'affichage (103, 203, 303, 403, DISP1, DISP) couplé à l'interface de signal de mesure (101, 201, 301, 401), et configuré pour afficher le signal de mesure (102, 202, 302, 402) acquis ;
une interface d'acquisition graphique (105, 205, 305, 405) configurée pour acquérir des données graphiques (106, 206, 306, 406) qui comprennent une représentation graphique d'un graphe ;
un processeur de données (107, 207, 307, 407) couplé à l'interface d'acquisition graphique (105, 205, 305, 405) et au dispositif d'affichage (103, 203, 303, 403, DISP1, DISP), et configuré pour extraire le graphe (108, 208, 308, 408) à partir des données graphiques (106, 206, 306, 406), et pour afficher le graphe (108, 208, 308, 408) extrait avec le signal de mesure (102, 202, 302, 402) sur le dispositif d'affichage (103, 203, 303, 403, DISP1, DISP).

2. Dispositif d'application de mesure (100, 200, 300, 400, OSC1, OSC) selon la revendication 1, dans lequel le processeur de données (107, 207, 307, 407) est en outre configuré pour extraire une trace (109, 209, 309, 409) du graphe (108, 208, 308, 408) à partir des données graphiques (106, 206, 306, 406).

3. Dispositif d'application de mesure (100, 200, 300, 400, OSC1, OSC) selon l'une quelconque des revendications précédentes, comprenant en outre une interface d'entrée utilisateur (212) configurée pour recevoir au moins l'une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406) ; et
dans lequel le processeur de données (107, 207, 307, 407) est en outre configuré pour adapter l'affichage du graphe (108, 208, 308, 408) extrait selon l'au moins une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406) reçues.

4. Dispositif d'application de mesure (100, 200, 300, 400, OSC1, OSC) selon l'une quelconque des revendications précédentes, dans lequel le processeur de données (107, 207, 307, 407) est en outre configuré pour extraire au moins l'une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406).

5. Dispositif d'application de mesure (100, 200, 300, 400, OSC1, OSC) selon la revendication 4, dans lequel le processeur de données (107, 207, 307, 407) est en outre configuré pour adapter l'affichage du graphe (108, 208, 308, 408) extrait selon l'au moins un élément extrait d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406).

6. Dispositif d'application de mesure (100, 200, 300, 400, OSC1, OSC) selon l'une quelconque des revendications 4 et 5, dans lequel le processeur de données (107, 207, 307, 407) est en outre configuré pour configurer automatiquement le dispositif d'application de mesure (100, 200, 300, 400, OSC1, OSC) en fonction d'au moins l'une de l'unité, de l'orientation et de la mise à l'échelle détectées pour l'au moins un axe.

7. Dispositif d'application de mesure (100, 200, 300, 400, OSC1, OSC) selon l'une quelconque des revendications précédentes, dans lequel le processeur de données (107, 207, 307, 407) est en outre configuré pour comparer le signal de mesure (102, 202, 302, 402) avec le graphe (108, 208, 308, 408) extrait, et pour sortir un signal de réussite/échec (315) en fonction de critères de réussite/échec prédéfinis.

8. Dispositif d'application de mesure (100, 200, 300, 400, OSC1, OSC) selon l'une quelconque des revendications précédentes, dans lequel le processeur de données (107, 207, 307, 407) est en outre configuré pour effectuer des calculs mathématiques prédéfinis avec le signal de mesure (102, 202, 302, 402) et le graphe (108, 208, 308, 408) extrait, et sortir un résultat (417) des calculs mathématiques prédéfinis.

9. Dispositif d'application de mesure (100, 200, 300, 400, OSC1, OSC) selon l'une quelconque des revendications précédentes, dans lequel le processeur de données (107, 207, 307, 407) est en outre configuré pour sélectionner au moins l'un d'une pluralité de signaux de mesure (102, 202, 302, 402) pour un traitement ultérieur avec le graphe (108, 208, 308, 408) extrait.

10. Dispositif d'application de mesure (100, 200, 300, 400, OSC1, OSC) selon l'une quelconque des revendications précédentes, dans lequel, si les données graphiques (106, 206, 306, 406) comprennent de multiples graphes (108, 208, 308, 408), ou si de multiples ensembles de données graphiques (106, 206, 306, 406) sont fournis, le processeur de données (107, 207, 307, 407) est en outre configuré pour permettre à un utilisateur de sélectionner au moins l'un des graphes (108, 208, 308, 408) disponibles pour un traitement ultérieur.

11. Procédé mis en œuvre par ordinateur permettant de faire fonctionner un dispositif d'application de mesure (100, 200, 300, 400, OSC1, OSC), le procédé comprenant :
l'acquisition (S1) de données graphiques (106, 206, 306, 406) qui comprennent une représentation graphique d'un graphe ;
l'extraction (S2) du graphe (108, 208, 308, 408) à partir des données graphiques (106, 206, 306, 406) ;
l'acquisition (S3) d'un signal de mesure (102, 202, 302, 402) ;
l'affichage (S4) du signal de mesure acquis (102, 202, 302, 402) ; et
l'affichage (S5) du graphe (108, 208, 308, 408) extrait avec le signal de mesure (102, 202, 302, 402).

12. Procédé mis en œuvre par ordinateur permettant de faire fonctionner un dispositif d'application de mesure (100, 200, 300, 400, OSC1, OSC) selon la revendication 11, comprenant en outre l'extraction d'une trace (109, 209, 309, 409) du graphe (108, 208, 308, 408) à partir des données graphiques (106, 206, 306, 406).

13. Procédé mis en œuvre par ordinateur permettant de faire fonctionner un dispositif d'application de mesure (100, 200, 300, 400, OSC1, OSC) selon les revendications 11 ou 12, comprenant en outre la réception d'au moins l'une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406) ; et
l'adaptation de l'affichage du graphe (108, 208, 308, 408) extrait selon l'au moins une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406) reçues.

14. Procédé mis en œuvre par ordinateur permettant de faire fonctionner un dispositif d'application de mesure (100, 200, 300, 400, OSC1, OSC) selon l'une quelconque des revendications 11 à 13, comprenant en outre l'extraction d'au moins l'une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406).

15. Procédé mis en œuvre par ordinateur permettant de faire fonctionner un dispositif d'application de mesure (100, 200, 300, 400, OSC1, OSC) selon la revendication 14, comprenant en outre l'adaptation automatique de l'affichage du graphe (108, 208, 308, 408) extrait selon l'au moins une d'une unité d'au moins un axe de système de coordonnées d'un système de coordonnées comprenant le graphe (108, 208, 308, 408), et d'une plage de valeurs de l'au moins un axe de système de coordonnées, et d'une mise à l'échelle de l'au moins un axe de système de coordonnées à partir des données graphiques (106, 206, 306, 406).

16. Procédé mis en œuvre par ordinateur permettant de faire fonctionner un dispositif d'application de mesure (100, 200, 300, 400, OSC1, OSC) selon l'une quelconque des revendications 14 et 15, comprenant en outre la configuration automatique du dispositif d'application de mesure (100, 200, 300, 400, OSC1, OSC) en fonction d'au moins l'une de l'unité, de l'orientation et de la mise à l'échelle détectées pour l'au moins un axe.

17. Procédé mis en œuvre par ordinateur permettant de faire fonctionner un dispositif d'application de mesure (100, 200, 300, 400, OSC1, OSC) selon l'une quelconque des revendications 11 à 16, comprenant en outre la comparaison du signal de mesure (102, 202, 302, 402) avec le graphe (108, 208, 308, 408) extrait ; et
la sortie d'un signal de réussite/échec (315) en fonction de critères de réussite/échec prédéfinis.

18. Procédé mis en œuvre par ordinateur permettant de faire fonctionner un dispositif d'application de mesure (100, 200, 300, 400, OSC1, OSC) selon l'une quelconque des revendications 11 à 17, comprenant en outre la réalisation de calculs mathématiques prédéfinis avec le signal de mesure (102, 202, 302, 402), et le graphe (108, 208, 308, 408) extrait ;
la sortie d'un résultat (417) des calculs mathématiques prédéfinis.

19. Procédé mis en œuvre par ordinateur permettant de faire fonctionner un dispositif d'application de mesure (100, 200, 300, 400, OSC1, OSC) selon l'une quelconque des revendications 11 à 18, comprenant en outre la sélection d'au moins l'un d'une pluralité de signaux de mesure (102, 202, 302, 402) pour un traitement ultérieur avec le graphe (108, 208, 308, 408) extrait.

20. Procédé mis en œuvre par ordinateur permettant de faire fonctionner un dispositif d'application de mesure (100, 200, 300, 400, OSC1, OSC) selon l'une quelconque des revendications 11 à 19, comprenant en outre, si les données graphiques (106, 206, 306, 406) comprennent de multiples graphes (108, 208, 308, 408), ou si de multiples ensembles de données graphiques (106, 206, 306, 406) sont fournis, la réception d'une sélection par l'utilisateur d'un utilisateur pour sélectionner au moins l'un des graphes (108, 208, 308, 408) disponibles pour un traitement ultérieur.

21. Produit programme informatique comprenant des instructions qui, lorsque le programme est exécuté par un ordinateur, amènent l'ordinateur à réaliser les étapes du procédé selon l'une quelconque des revendications 11 à 20.
